# EUROPEAN PATENT SPECIFICATION

(11) **EP 1 585 178 B1**
(45) Date of publication and mention of the grant of the patent: **31.08.2011**
(21) Application number: 03701066.7
(22) Date of filing: 14.01.2003
(51) Int. Cl.: H01L 31/048, H01L 31/05

(54) **SOLAR CELL MODULE ASSEMBLY, WIRING SYSTEM AND SOLAR POWER G ENERATION SYSTEM**
SOLARZELLENMODULBAUGRUPPE, VERDRAHTUNGSSYSTEM UND SOLARSTROMERZEUGUNGSSYSTEM
ENSEMBLE DE MODULES SOLAIRES, SYSTEME DE CABLAGE ET SYSTEME DE GENERATION D'ELECTRICITE SOLAIRE

(43) Date of publication of application: 12.10.2005
(73) Proprietor: MITSUBISHI HEAVY INDUSTRIES, LTD., Tokyo 108-8215 (JP)
(72) Inventor: Horioka, T., Nagasaki Shipyard & Machinery Works, Nagasaki-shi, Nagasaki 850-8610 (JP); Koga, Minoru, Nagasaki Shipyard & Machinery Works, Nagasaki-shi, Nagasaki 850-8610 (JP); Ogawa, K., Nagasaki Shipyard & Machinery Works, Nagasaki-shi, Nagasaki 850-8610 (JP); Oka, Nobuki, Mitsubishi Heavy Ind., Ltd., Minato-ku, Tokyo 108-8215 (JP)
(74) Representative: HOFFMANN EITLE
(86) International application number: PCT/JP2003/000205
(87) International publication number: WO 2004/064165

(56) References cited:
- JP-A- 7 131 045
- JP-A- 10 135 499
- JP-A- 2000 164 911
- JP-A- 2000 277 787
- JP-A- 2002 185 029
- JP-A- 2002 276 109
- JP-A- 2002 289 893
- US-A- 4 321 416

## Description

### Technical Field

The present invention relates to a photovoltaic solar cell module assembly and a wiring system thereof, and a photovoltaic power system.

### Background Art

In general, an operating voltage of a photovoltaic solar cell module is lower than that of a power conditioner. Thus, a plurality of photovoltaic solar cell modules are connected to a power conditioner after connected in series. If the number of photovoltaic solar cell modules is increased, a plurality of series connections (cell arrays) are made and wiring which connects the cell arrays in parallel is connected to the power conditioner.

In fact, when a photovoltaic power system is installed, integer n that is close to the number obtained by dividing the operating voltage (for example, 200V) of the power conditioner by the operating voltage of the photovoltaic solar cell modules is first selected. The integer n is handled as the number of the photovoltaic solar cell modules in series connection. Next, the number n of the modules in series connection is multiplied by power output Vo of the photovoltaic solar cell modules to obtain a product. The product (n x Vo) is equivalent to the power output of a single row. Next, integer m that is close to the number obtained by dividing the power output of the photovoltaic power system by the power output (n x Vo) of the single row is selected.
The integer m is handled as the number of cell arrays in parallel connection.

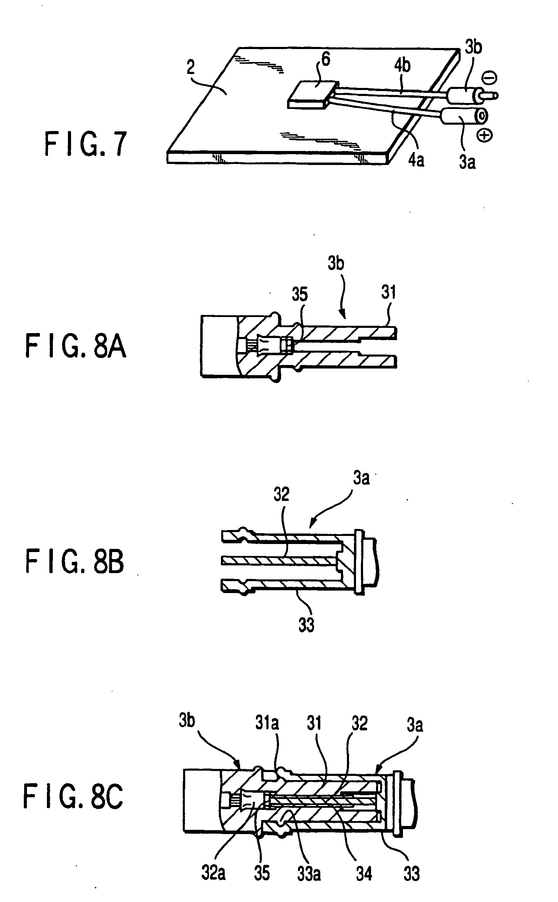

A conventional photovoltaic solar cell module 2 comprises a terminal box 6 whose back surface is attached thereto, a pair of cables 4a and 4b connected respectively to positive and negative terminals inside the terminal box 6, and male and female connectors 3a and 3b attached respectively to distal ends of the cables 4a and 4b, as shown in FIG. 7.

The female connector 3b has a contact element 35 at the deepest portion in a hole of an insulation guide 31 as shown in FIG. 8A. The male connector 3a has a pin 32 in a hollow portion of an insulation guide 33 as shown in FIG. 8B. When the male connector 3a is inserted into the female connector 3b, a distal end of the pin 32 is fitted in a recess of the contact element 35 and both the connectors thereby become conductive as shown in FIG. 8C.

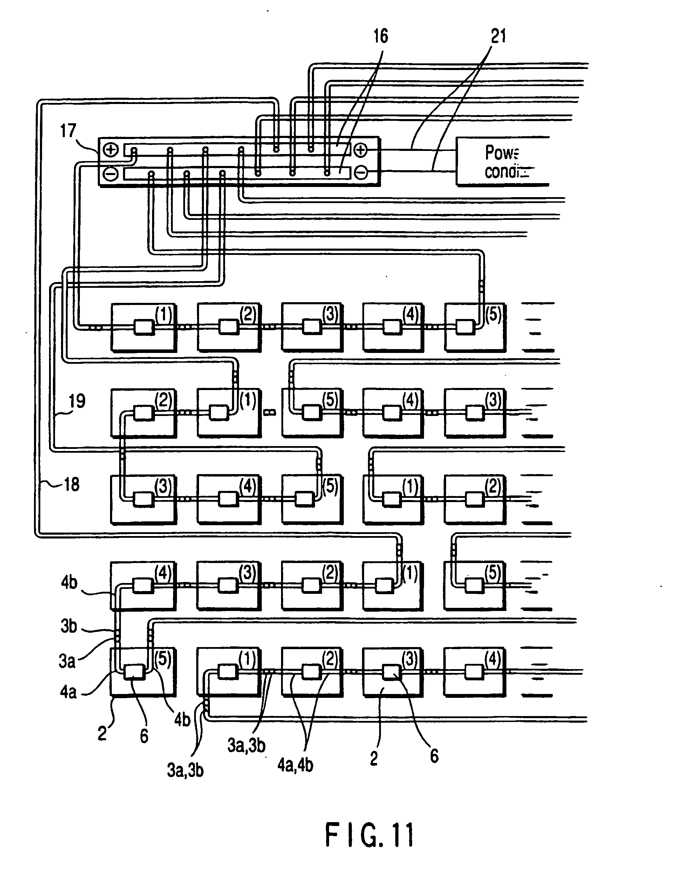

In the conventional photovoltaic power system, as shown in FIG. 11, the power generated in a plurality of photovoltaic solar cell modules 2 is collected to positive and negative terminals 16 in a junction box 17 by extension cables 18 and 19, output from the junction box 17 to a power conditioner 20 by a connecting cable 21. In the power conditioner 20, the DC power is converted into the AC power, which is fed to each of electric devices.

Incidentally, when the conventional system is installed, the number of series connection of photovoltaic solar cell modules 2 and the number of parallel connection thereof are designed, and members of the extension cables 18, 19 and the like whose number corresponds to the number of modules are prepared. The photovoltaic solar cell modules 2 are connected while the number of modules in series connection is counted at the installation place. When the wiring connection of a single row of the modules is completed, the extension cables 18 and 19 are connected to both side ends of the modules. The extension cables 18 and 19 are connected parallel at the positive and negative terminals 16 inside the junction box 17.

In the conventional system, however, if each of the photovoltaic solar cell modules is small in area and power output similarly to a roofing tile-integrated photovoltaic solar cell module, the number of photovoltaic solar cell modules is increased, the number of a row of photovoltaic solar cell modules is also increased, and errors easily occur in counting the number of modules in series connection.

In addition, particularly, since steps of the expensive and dangerous rooftop operation are increased, installation costs are increased. For this reason, simplifying the design of wiring connection of the photovoltaic solar cell modules, improving installation operability at the installation place (on the roof) and reducing the operation steps are important problems.

JP 2002/185029 A discloses a serial string for a solar battery module with which it is possible to perform parallel connection work.

JP 2000/164911 A discloses a solar cell which can be installed on a sun-roof of a vehicle and which can be connected to a separated solar cell.

### Disclosure of Invention

The present invention has been accomplished to solve the above-described problems. The object of the present invention is to provide a photovoltaic power system, capable of facilitating the wiring connection of photovoltaic solar cell modules.

A photovoltaic power system according to the present invention is as defined in claim 1.

The wiring system in which a plurality of photovoltaic solar cell module assemblies is connected in parallel is formed by connecting the positive electrodes of the adjacent photovoltaic solar cell module assemblies to each other and the negative electrodes thereof to each other.

In this case, it may be preferable that the photovoltaic solar cell modules should be integral with the base members (roofing tiles, construction materials and the like).

By connecting a plurality of photovoltaic solar cell module assemblies in parallel, a photovoltaic power system whose operating voltage is set to be substantially equal to a power conditioner operating voltage or to be an operating voltage that is an integral submultiple of the power conditioner operating voltage is formed.

In the present invention, the photovoltaic solar cell module assemblies capable of generating an operating voltage corresponding to the operating voltage of the power conditioner by preliminarily connecting a plurality of photovoltaic solar cell modules in series are prepared, and the photovoltaic power system is formed by connecting the photovoltaic solar cell module assemblies in parallel.

According to the present invention, it is unnecessary to install the photovoltaic solar cell modules while counting the number of modules in series connection at the installation place or connect the photovoltaic solar cell modules in parallel at the installation place. For this reason, design in wiring connection of the photovoltaic solar cell modules can be simplified and the installation operability at the installation place can also be improved.

The photovoltaic solar cell module assembly according to the present invention may be characterized in that a plurality of photovoltaic solar cell modules are connected in series and that each of positive and negative electrodes on both ends of the series-connected photovoltaic solar cell modules is bifurcated. This photovoltaic solar cell module assembly may be connected in parallel with the adjacent photovoltaic solar cell module assembly by connecting their positive electrodes to each other and their negative electrodes to each other.

The photovoltaic solar cell modules inside the photovoltaic solar cell module assembly may be connected in series via connectors attached to distal ends of the cables led from the junction box or the junction boxes may be connected directly with cables. Each of positive and negative electrodes on both ends of the photovoltaic solar cell module assembly is bifurcated, cables are connected to the respective bifurcated electrodes, and a connector is attached to the distal end of each cable to form two pairs of positive and negative electrode terminals. The positive and negative electrode terminals may be grouped into two sets of paired positive and negative electrodes, the connectors may be attached to the distal ends of the cables, the distal ends of the cables may be tied while insulated from each other, or the connectors at the distal ends may be integrated while insulated from each other.

Furthermore, it is preferable that a backflow preventing diode should be provided inside the single photovoltaic solar cell module assembly.

The cell element of the photovoltaic solar cell module used in the present invention is not limited particularly, but may be any silicon-based or compound-based element. The silicon may be any one of polycrystalline silicon, monocrystalline silicon, an amorphous silicon thin film, a microcrystalline silicon thin film, a monocrystalline silicon thin film, a polycrystalline silicon thin film, and their combination. The crystalline silicon-based photovoltaic solar cell is a photovoltaic solar cell which contains crystalline silicon as its semiconductor material. The present invention can be applied to solar batteries of any kinds that can be classified into monocrystal, polycrystal and microcrystal. The amorphous silicon-based photovoltaic solar cell is a photovoltaic solar cell which contains amorphous silicon as its semiconductor material. The compound-based photovoltaic solar cell is a photovoltaic solar cell which contains garium arsenide (GaAs), CuInSe₂ called CIS base, and the like, as its semiconductor material.

According to the present invention, since it is unnecessary to install the photovoltaic solar cell modules while counting the number of modules in series connection at the installation place, errors in wiring are not generated due to errors in counting.

In addition, since the photovoltaic solar cell module assemblies have only to be connected in parallel at the installation place, the number of installation steps at the installation place is reduced, dangerous rooftop wiring operations are simplified, and the installation costs are remarkably reduced.

### Brief Description of Drawings

FIG. 1A is a perspective view of a photovoltaic solar cell module assembly according to an embodiment of the present invention as seen from a top surface side thereof;
FIG. 1B is a perspective view of the photovoltaic solar cell module assembly as seen from a back surface side thereof;
FIG. 2A is a perspective view of a photovoltaic solar cell module assembly according to another embodiment of the present invention as seen from a top surface side thereof;
FIG. 2B is a perspective view of the photovoltaic solar cell module assembly according to another embodiment as seen from a back surface side thereof;
FIG. 3 is a perspective view of a photovoltaic solar cell module arranged at an end portion of the photovoltaic solar cell module assembly;
FIG. 4 is a perspective view of a photovoltaic solar cell module arranged at a portion (middle portion) other than the end portion of the photovoltaic solar cell module assembly;
FIG. 5 is a perspective view of an installation example of tying negative and positive electrode cables;
FIG. 6 is a perspective view of another installation example of tying negative and positive electrode cables;
FIG. 7 is a perspective view showing a conventional photovoltaic solar cell module and connectors of a trunk side (extension cable side);
FIG. 8A is a cross-sectional view of a female connector (of negative side);
FIG. 8B is a cross-sectional view of a male connector (of positive side);
FIG. 8C is a cross-sectional view of connection of the male and female connectors;
FIG. 9A is a circuit diagram pictorially showing a photovoltaic solar cell module assembly;
FIG. 9B is a circuit diagram pictorially showing another photovoltaic solar cell module assembly;
FIG. 9C is a circuit diagram pictorially showing still another photovoltaic solar cell module assembly;
FIG. 9D is a circuit diagram pictorially showing a photovoltaic power system;
FIG. 10A is a circuit diagram showing a photovoltaic solar cell module assembly according to still another embodiment;
FIG. 10B is a circuit diagram showing a photovoltaic solar cell module assembly according to still another embodiment;
FIG. 10C is a circuit diagram showing a photovoltaic solar cell module assembly according to still another embodiment; and
FIG. 11 is a block diagram showing a conventional photovoltaic power system.

### Best Mode for Carrying Out the Invention

Embodiments of the present invention will be explained below with reference to the accompanying drawings.

### (First Example)

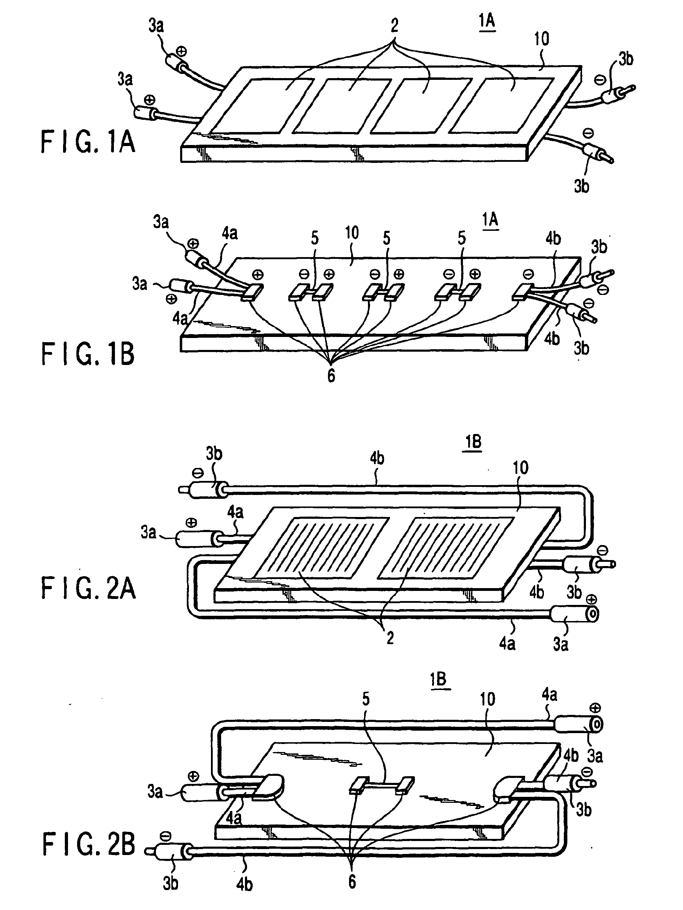

FIGS. 1A and 1B schematically show an example of a photovoltaic solar cell module assembly employed in a photovoltaic power system in which an operating voltage for each photovoltaic solar cell module is 50V and an operating voltage of a power conditioner is 200V. In a photovoltaic solar cell module assembly 1A of the first example, four photovoltaic solar cell modules 2 are aligned on a common base member 10 as shown in FIG. 1A and connected in series as shown in FIG. 1B. Each of positive and negative terminals of both side ends is bifurcated. In other words, the positive terminal and the negative terminal inside a terminal box 6, of the adjacent photovoltaic solar cell modules 2, are connected in series by an inter-module coupling cable 6 and connectors. The bifurcated positive electrode cables 4a are connected to the positive terminal on a one-side end of the row of modules and the bifurcated negative electrode cables 4b are connected to the negative terminal on the other side end of the row of modules.

Connectors 3a are attached to distal ends of the bifurcated cables 4a, respectively, and connectors 3b are attached to distal ends of the bifurcated cables 4b, respectively. The connectors can be further connected to the other photovoltaic solar cell module assembly 1A.

The material of the base member 10 may be any one of ceramic, resin and metal. The base member 10 itself may be a roof tile, an instruction member or the like.

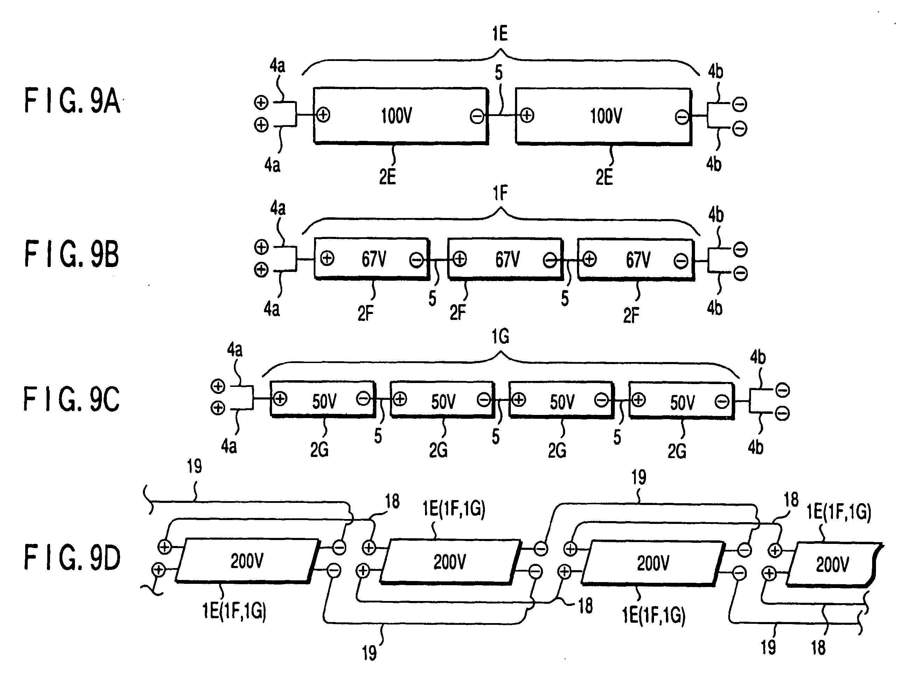

In the current home photovoltaic power system, the output voltage of the photovoltaic solar cell, i.e. the input voltage of the power conditioner needs to be approximately 200V. If the voltage of each of currently available photovoltaic solar cell modules is, for example, 50V, which depends on the module size, four cell modules 2G need to be connected in series as shown in FIG. 9C to obtain the output voltage of 200V corresponding to the power conditioner operating voltage of 200V.

Moreover, positive electrodes of adjacent photovoltaic solar cell module assemblies 1G having the output voltage of 200V are connected with the extension cables 18 and negative electrodes of adjacent photovoltaic solar cell module assemblies 1G are connected with the extension cables 19. Thus, a photovoltaic power system in which the photovoltaic solar cell module assemblies 1G having the output voltage of 200V are connected in parallel can be configured as shown in FIG. 9D.

In this method of wiring connection, the time of the rooftop operations is remarkably reduced and the installation is simplified.

### (First Embodiment)

FIGS. 2A and 2B schematically show an example of a photovoltaic solar cell module assembly in a case where an operating voltage for each photovoltaic solar cell module is 100V and a power conditioner operating voltage is 200V. In a photovoltaic solar cell module assembly 1B of the first embodiment, two photovoltaic solar cell modules 2 are arranged adjacently as shown in FIG. 2A and connected in series as shown in FIG. 2B. A pair of positive and negative terminals are guided from each of the terminal boxes 6 of both side ends. In other words, the positive terminal and the negative terminal inside the terminal boxes 6, of the adjacent photovoltaic solar cell modules 2, are connected in series by the inter-module coupling cable 6 and connectors. The bifurcated positive and negative electrode cables 4a and 4b are connected to the positive and negative terminals on a one-side end of the row of modules and the bifurcated positive and negative electrode cables 4a and 4b are connected to the positive and negative terminals on the other side end of the row of modules.

Connectors 3a are attached to distal ends of the bifurcated cables 4a, respectively, and connectors 3b are attached to distal ends of the bifurcated cables 4b, respectively. The connectors can be further connected to the other photovoltaic solar cell module assembly 1B.

In the photovoltaic solar cell module assembly of this embodiment, one of the positive electrode cables 3a is extended and the positive connector 3a thereof is arranged in the vicinity of the negative connector 3b of the cable 4b of the opposite side.

In the current home photovoltaic power system, the output voltage of the photovoltaic solar cell, i.e. the input voltage of the power conditioner needs to be approximately 200V. If the voltage of each of currently available photovoltaic solar cell modules is, for example, 100V, which depends on the module size, two cell modules 2E need to be connected in series as shown in FIG. 9A to obtain the output voltage of 200V corresponding to the power conditioner operating voltage of 200V.

Moreover, positive electrodes of adjacent photovoltaic solar cell module assemblies 1E having the output voltage of 200V are connected with the extension cables 18 and negative electrodes of adjacent photovoltaic solar cell module assemblies 1E are connected with the extension cables 19. Thus, a photovoltaic power system in which the photovoltaic solar cell module assemblies 1E having the output voltage of 200V are connected in parallel can be configured as shown in FIG. 9D.

In this method of wiring connection, the time of the rooftop operations is remarkably reduced and the installation is simplified.

### (Second Embodiment)

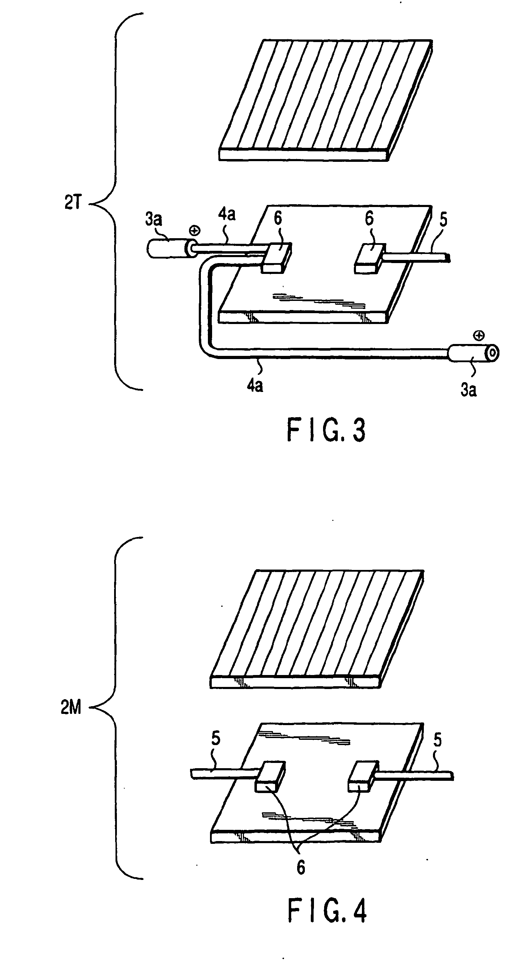

Next, a second embodiment of the present invention will be explained with reference to FIGS. 3, 4, 9A-9D, and 10A-10C.

FIG. 3 schematically shows a photovoltaic solar cell module arranged at an end portion of the photovoltaic solar cell module assembly. FIG. 4 schematically shows a photovoltaic solar cell module arranged at a portion (middle portion) other than the end portion of the photovoltaic solar cell module assembly.

In the photovoltaic solar cell module assembly of this embodiment, photovoltaic solar cell module 2T shown in FIG. 3 is arranged on both side ends of the module assembly and photovoltaic solar cell module 2M shown in FIG. 4 is arranged at the middle portion of the module assembly. The photovoltaic solar cell modules 2M are connected with the inter-module coupling cable 5 and the modules 2T of both sides are connected to the modules 2M of the middle portion. Thus, the output voltage of 200V corresponding to the power conditioner operating voltage of 200V can be obtained.

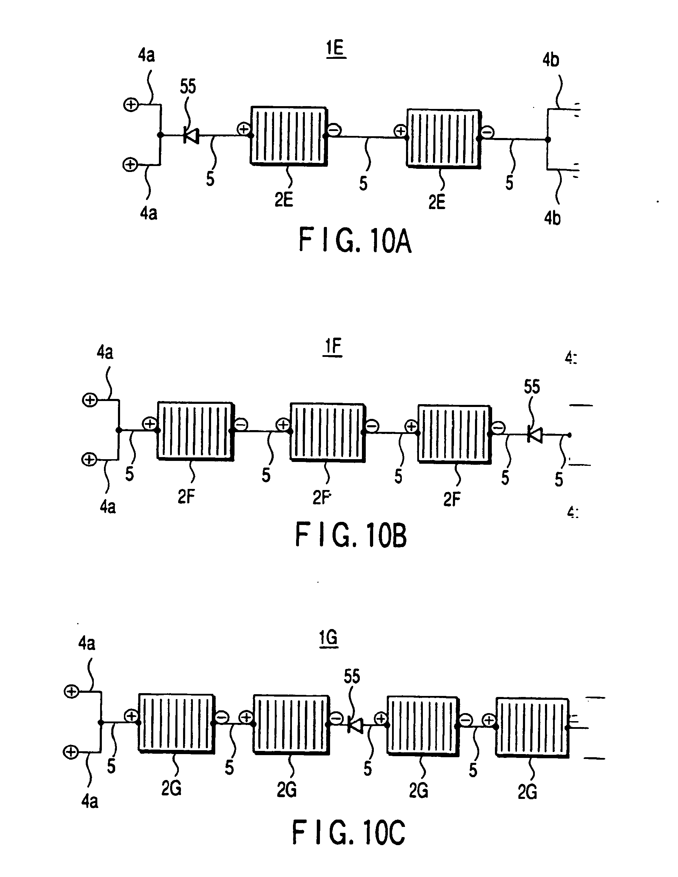

For example, if the operating voltage of each photovoltaic solar cell module is 100V, two photovoltaic solar cell modules are connected in series as shown in FIGS. 9A and 10A to correspond to the power conditioner operating voltage of 200V.

In addition, for example, if the operating voltage of each photovoltaic solar cell module is 67V, three photovoltaic solar cell modules are connected in series as shown in FIGS. 9B and 10B to correspond to the power conditioner operating voltage of 200V.

Moreover, for example, if the operating voltage of each photovoltaic solar cell module is 50V, four photovoltaic solar cell modules are connected in series as shown in FIGS. 9C and 10C to correspond to the power conditioner operating voltage of 200V.

The photovoltaic solar cell module assembly thus configured to have the operating voltage of 200V is connected in parallel with adjacent photovoltaic solar cell module assemblies as shown in FIG. 9D. In this connecting method, the time of the rooftop operations is remarkably reduced and the installation is simplified.

### (Third Embodiment)

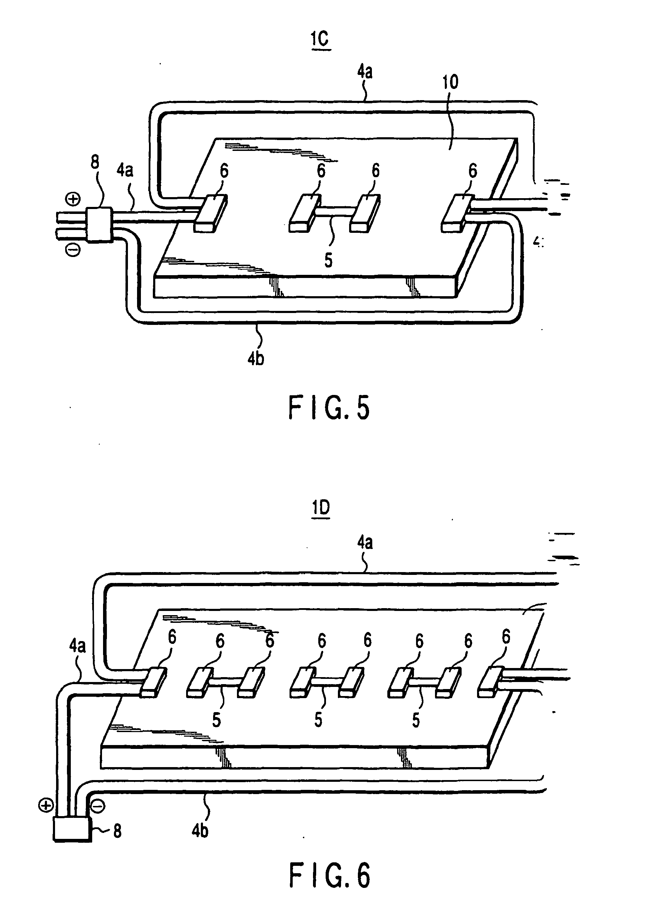

Next, a third embodiment of the present invention will be explained with reference to FIGS. 5 and 6.

In a photovoltaic solar cell module assembly 1C (with the structure substantially equal to that of the module assembly 1B of the second embodiment) in which two photovoltaic solar cell modules 2 are mounted on the base member 10, a pair of positive and negative cables 4a and 4b may be preliminarily tied on the ground with a tie member 8 formed of an adhesive tape and a fastening band, as shown in FIG. 5, before bringing the module assembly onto the roof.

In addition, in a photovoltaic solar cell module assembly 1D (with the structure substantially equal to that of the module assembly 1A of the first example) in which four photovoltaic solar cell modules 2 are mounted on the base member 10, a pair of positive and negative cables 4a and 4b may be preliminarily tied on the ground with the tie member 8 formed of an adhesive tape and a fastening band, as shown in FIG. 6, before bringing the module assembly onto the roof.

Therefore, the (rooftop) operability is further improved and the installation costs are reduced.

### (Fourth Embodiment)

Next, a fourth embodiment of the present invention will be explained with reference to FIGS. 10A to 10C.

In a photovoltaic solar cell module assembly 1E (with the structure substantially equal to that of the module assembly 1B of the first embodiment) comprising two photovoltaic solar cell modules 2E, a backflow preventing diode 55 is inserted into the cable 5 immediately before the positive electrode side of the cable is bifurcated, as shown in FIG. 10A, to prevent backflow of a DC current generated in the modules 2E.

In a photovoltaic solar cell module assembly 1F comprising three photovoltaic solar cell modules 2F, the backflow preventing diode 55 is inserted into the cable 5 immediately before the positive electrode side of the cable is bifurcated, as shown in FIG. 10B, to prevent backflow of a DC current generated in the modules 2F.

In a photovoltaic solar cell module assembly 1G (with the structure substantially equal to that of the module assembly 1A of the first example) comprising four photovoltaic solar cell modules 2G, the backflow preventing diode 55 is inserted into a middle portion of the module assembly (or between the middle modules), as shown in FIG. 10C, to prevent backflow of a DC current generated in the modules 2G.

Thus, the backflow preventing diode 55 is arranged anywhere inside the wiring circuit of the photovoltaic solar cell module and the position of arrangement is arbitrary.

By inserting the backflow preventing diode 55 into the wiring circuit, the output is made further stable in the photovoltaic solar cell module assembly comprising a number of modules, the wiring system and the photovoltaic power system.

The power element built in the photovoltaic solar cell module, in the above-described embodiments has various types such as crystalline silicon base, amorphous silicon base, compound base and the like. The present invention can be applied to any type of the power element.

The crystalline silicon-based photovoltaic solar cell is a photovoltaic solar cell containing crystalline silicon as the semiconductor material.
The photovoltaic solar cell can be further classified into single crystal, polycrystal and microcrystal.

The amorphous silicon-based photovoltaic solar cell contains amorphous silicon as the semiconductor material.

The compound-based photovoltaic solar cell contains garium arsenide (GaAs), CuInSe₂ called CIS base, and the like, as the semiconductor material.

According to the present invention, the photovoltaic solar cell module assembly which generates the operating voltage corresponding to the power conditioner operating voltage is prepared by connecting a plurality of photovoltaic solar cell modules in series, and the photovoltaic power system is formed by connecting the photovoltaic solar cell module assemblies in parallel. Thus, it is unnecessary to install the photovoltaic solar cell modules while counting the number of modules in series connection at the installation place and errors in wiring are not generated due to errors in counting.

In addition, according to the present invention, the photovoltaic solar cell module assemblies have only to be connected in parallel at the installation place. Therefore, the number of installation steps at the installation place is reduced, dangerous rooftop wiring operations are simplified, and the installation costs are remarkably reduced.

Furthermore, according to the present invention, the photovoltaic solar cell modules do not need to be connected in parallel. Therefore, design in wiring connection of the photovoltaic solar cell modules can be simplified and the installation operability at the installation place can also be improved.

## Claims

1. A photovoltaic power system, comprising:
a plurality of photovoltaic solar cell module assemblies, wherein each solar cell module assembly comprises:
a base member (10);
a plurality of photovoltaic solar cell modules (2) provided on said base member to receive light irradiation to generate a predetermined power output;
a positive terminal (6) and a negative terminal (6) which are provided for each of said plurality of photovoltaic solar cell modules; and
an inter-module coupling cable (5) connecting every adjacent two of said plurality of photovoltaic solar cell modules from said negative terminal of one of the adjacent two to said positive terminal of the other of the adjacent two such that said plurality of photovoltaic solar cell modules are connected in series,
**characterized by** further comprising:
two positive connection cables (4a) connected with said positive terminal in one end of the series connection of said plurality of photovoltaic solar cell modules; and
two negative connection cables (4b) connected with said negative terminal in the other end of the series connection of said plurality of photovoltaic solar cell modules,
wherein one of said two positive connection cables extends to said negative terminal in said other end, and
wherein one of said two negative connection cables extends to said positive terminal in said one end,
wherein said positive terminal and said negative terminal of each of said plurality of photovoltaic solar cell modules are provided in different and separated terminal boxes,
wherein one of said two positive connection cables and one of said two negative connection cables in said other end of said first photovoltaic solar cell module assembly are connected to one of said two positive connection cables and one of said two negative connection cables in said one end of said second photovoltaic solar cell module assembly such that said first and second photovoltaic solar cell modules assemblies are connected in parallel, and
wherein an operating voltage of the photovoltaic solar cell module assemblies is set to be substantially equal to a power conditioner operating voltage or to be an operating voltage that is an integer submultiple of the power conditioner operating voltage.

## Patentansprüche

1. Photovoltaik-Stromanlage, umfassend:
eine Vielzahl an Photovoltaik-Solarzellenmodulanordnungen, wobei jede Solarzellenmodulanordnung umfasst:
ein Basiselement (10);
eine Vielzahl an Photovoltaik-Solarzellenmodulen (2), die an dem Basiselement vorgesehen sind, um Lichteinstrahlung aufzunehmen, um eine vorgegebene Ausgangsleistung zu erzeugen;
einen positiven Anschluss (6) und einen negativen Anschluss (6), die für jedes der Photovoltaik-Solarzellenmodule vorgesehen sind; und
ein Zwischenmodulkopplungskabel (5), das jeweils zwei angrenzende von der Vielzahl an Photovoltaik-Solarzellenmodulen von dem negativen Anschluss von einem der angrenzenden zwei mit dem positiven Anschluss von dem anderen der angrenzenden zwei so verbindet, dass die Vielzahl der Photovoltaik-Solarzellenmodule in Reihe verbunden ist,
**gekennzeichnet durch**, ferner umfassend:
zwei positive Verbindungskabel (4a), die mit dem positiven Anschluss an einem Ende der Reihenverbindung der Vielzahl an Photovoltaik-Solarzellenmodulen verbunden sind; und
zwei negative Verbindungskabel (4b), die mit dem negativen Anschluss an dem anderen Ende der Reihenverbindung der Vielzahl an Photovoltaik-Solarzellenmodulen verbunden sind,
wobei eines der zwei positiven Verbindungskabel sich hin zu dem negativen Anschluss an dem anderen Ende erstreckt, und
wobei eines der zwei negativen Verbindungskabel sich zu dem positiven Anschluss an dem anderen Ende erstreckt,
wobei der positive Anschluss und der negative Anschluss von jedem der Vielzahl an Photovoltaik-Solarzellenmodulen in verschiedenen und getrennten Anschlussboxen vorgesehen sind,
wobei eines der zwei positiven Verbindungskabel und eines der zwei negativen Verbindungskabel an dem anderen Ende von der ersten Photovoltaik-Solarzellenmodulanordnung mit einem der zwei positiven Verbindungskabel und einem der zwei negativen Verbindungskabel an dem einen Ende der zweiten Photovoltaik-Solarzellenmodulanordnung verbunden ist, so dass die erste und zweite Photovoltaik-Solarzellenmodulanordnung parallel verbunden sind, und
wobei eine Betriebsspannung der Photovoltaik-Solarzellenmodulanordnungen eingestellt wird, um im Wesentlichen gleich einer Leistungskonditionierer-Betriebsspannung zu sein oder um eine Betriebsspannung zu sein, die ein ganzzahliges Untervielfaches der Leistungskonditionierer-Betriebsspannung ist.

## Revendications

1. Système de puissance photovoltaïque, comprenant :
une pluralité d'ensembles de modules de cellules solaires photovoltaïques, où chaque ensemble de modules de cellules solaires comprend :
un élément de base (10);
une pluralité de modules (2) de cellules solaires photovoltaïques prévus sur ledit élément de base pour recevoir une irradiation lumineuse afin de générer une sortie de puissance prédéterminée ;
une borne positive (6) et une borne négative (6) qui sont prévues pour chacun de ladite pluralité de modules de cellules solaires photovoltaïques ; et
un câble (5) de couplage inter-module reliant chaque deux modules adjacents de ladite pluralité de modules de cellules solaires photovoltaïques depuis ladite borne négative de l'un des deux modules adjacents à ladite borne positive de l'autre des deux modules adjacents de sorte que ladite pluralité de modules de cellules solaires photovoltaïques soient reliés en série,
**caractérisé par** le fait de comprendre en outre :
deux câbles (4a) de raccordement positifs reliés à ladite borne positive dans une extrémité du montage en série de ladite pluralité de modules de cellules solaires photovoltaïques ; et
deux câbles (4b) de raccordement négatifs reliés à ladite borne négative dans l'autre extrémité du montage en série de ladite pluralité de modules de cellules solaires photovoltaïques,
où l'un desdits deux câbles de raccordement positifs s'étend jusqu'à ladite borne négative dans ladite autre extrémité, et
où l'un desdits deux câbles de raccordement négatifs s'étend jusqu'à ladite borne positive dans ladite une extrémité,
où ladite borne positive et ladite borne négative de chacun de ladite pluralité de modules de cellules solaires photovoltaïques sont prévues dans des boîtes à bornes différentes et séparées,
où l'un desdits deux câbles de raccordement positifs et l'un desdits deux câbles de raccordement négatifs dans ladite autre extrémité dudit premier ensemble de modules de cellules solaires photovoltaïques sont reliés à l'un desdits deux câbles de raccordement positifs et l'un desdits deux câbles de raccordement négatifs dans ladite une extrémité dudit deuxième ensemble de modules de cellules solaires photovoltaïques de sorte que lesdits premier et deuxième ensembles de modules de cellules solaires photovoltaïques soient reliés en parallèle, et
où une tension de fonctionnement des ensembles de modules de cellules solaires photovoltaïque est réglée de manière à ce qu'elle soit sensiblement égale à une tension de fonctionnement du conditionneur de puissance ou de manière à ce qu'elle soit une tension de fonctionnement qui est un sous-multiple entier de la tension de fonctionnement du conditionneur de puissance.
